# EUROPEAN PATENT APPLICATION

(11) **EP 4 726 004 A1**
(43) Date of publication of application: **15.04.2026**
(21) Application number: 24839858.8
(22) Date of filing: 09.04.2024
(51) Int. Cl.: C09G 1/02, C09K 3/14, H01L 21/3105

(54) **POLISHING COMPOSITION FOR SEMICONDUCTOR PROCESS AND SUBSTRATE POLISHING METHOD USING SAME**

(30) Priority: 12.07.2023 KR 20230090374
(71) Applicant: SK enpulse Co., Ltd., Seongnam-si, Gyeonggi-do 13453 (KR)
(72) Inventor: HAN, Deoksu, Seoul 03142 (KR); LEE, Sungmin, Seoul 03142 (KR); PARK, Hanteo, Seoul 03142 (KR); CHOI, Yongsoo, Seoul 03142 (KR)
(74) Representative: BCKIP Part mbB
(86) International application number: PCT/KR2024/004719
(87) International publication number: WO 2025/014039

(57) **Abstract**

A polishing composition for a semiconductor process according to one embodiment of the present disclosure includes polishing particles and a first polishing control agent which is a cationic polymer.

The first polishing control agent includes a cationic residue derived from a cationic compound and an acrylamide-based residue.

The acrylamide-based residue includes a first acrylamide-based residue represented by Chemical Formula 1-1 below and a second acrylamide-based residue represented by Chemical Formula 1-2 below, which is distinct from the first acrylamide-based residue.

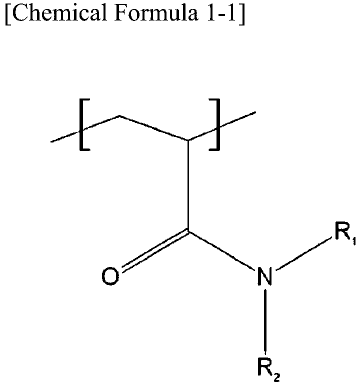

In Chemical Formula 1-1, R₁ and R₂ are each independently hydrogen, a methyl group, or an ethyl group.

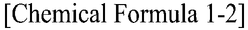

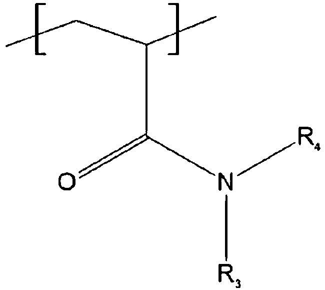

In Chemical Formula 1-2, R₃ is hydrogen, a methyl group, or an ethyl group, and
R₄ is an alkyl group having 3 to 10 carbon atoms or an alkoxyalkyl group having 2 to 10 carbon atoms.

When the polishing composition having such characteristics is applied to a CMP process, the polishing composition may provide a polished substrate having a smoother surface while maintaining a polishing speed of at least a predetermined level.

## Description

### [TECHNICAL FIELD]

### [Cross-Reference to Related Application]

The present application claims priority to Korean Patent Application No. 10-2023-0090374 filed on July 12, 2023, and the content of the patent document is incorporated herein in its entirety by reference.

The present disclosure relates to a polishing composition for a semiconductor process and a substrate polishing method using the same.

### [BACKGROUND ART]

As semiconductor devices are further miniaturized and made higher in density, finer pattern formation technology is being used. Accordingly, surface structures of semiconductor devices become more complex and step differences of interlayer films also become larger. In manufacturing semiconductor devices, a chemical mechanical polishing (Chemical Mechanical Polishing: hereinafter referred to as "CMP") process is used as a planarization technology for removing a step difference in a specific film formed on a substrate.

In the CMP process, while a slurry is provided to a polishing pad, a substrate is pressurized and rotated, and the surface is polished. Depending on a step of the process, an object to be planarized varies, and in this case, physical properties of the slurry applied also differ.

Polishing after metal wirings are formed requires maintaining a sufficient polishing rate and polishing speed while minimizing dishing and the like.

The background art described above is technical information that the inventor possessed for deriving the present invention or acquired in the process of deriving the present invention, and may not necessarily be a known technology disclosed to the general public before the filing of the present application.

### [PRIOR ART DOCUMENTS]

### [PATENT DOCUMENTS]

(Patent Document 1) Korean patent publication No. 10-2019-0105770
(Patent Document 2) Korean patent publication No. 10-2019-0060226

### [DETAILED DESCRIPTION OF THE INVENTION]

### [TECHNICAL PROBLEM]

An object of the present disclosure is to provide a polishing composition for a semiconductor process, etc., which, when applied to a CMP process, may polish a surface of a substrate to be polished more smoothly while maintaining a polishing speed of at least a predetermined level.

### [SOLUTION TO PROBLEM]

A polishing composition for a semiconductor process according to one embodiment of the present specification includes polishing particles and a first polishing control agent which is a cationic polymer.

The first polishing control agent includes a cationic residue derived from a cationic compound and an acrylamide-based residue.

The acrylamide-based residue includes a first acrylamide-based residue represented by Chemical Formula 1-1 below and a second acrylamide-based residue represented by Chemical Formula 1-2 below, which is distinct from the first acrylamide-based residue.

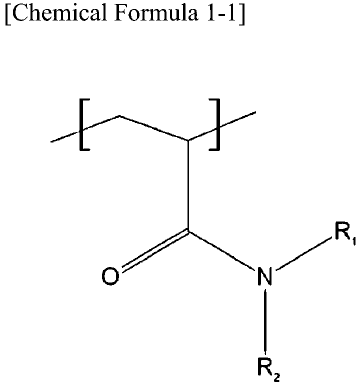

In Chemical Formula 1-1, R₁ and R₂ are each independently any one selected from hydrogen and an alkyl group having 1 to 3 carbon atoms.

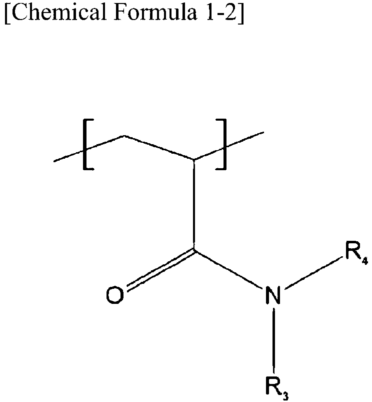

In Chemical Formula 1-2, R₃ is any one selected from hydrogen and an alkyl group having 1 to 3 carbon atoms, and R₄ is an alkyl group having 1 to 10 carbon atoms or an alkoxyalkyl group having 2 to 10 carbon atoms.

The acrylamide-based residue may further include a vinyl ester-based residue represented by Chemical Formula 2 below.

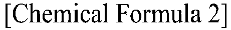

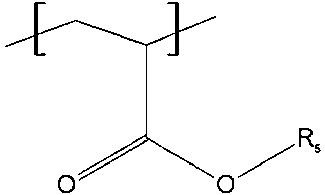

In Chemical Formula 2, R₅ is a hydroxyalkyl group having 1 to 10 carbon atoms.

The cationic residue may be a residue derived from a quaternary ammonium-based compound.

The first polishing control agent may include 3 parts by weight to 160 parts by weight of the acrylamide-based residue based on 100 parts by weight of the cationic residue.

The acrylamide-based residue may include 50 parts by weight to 260 parts by weight of the second acrylamide-based residue based on 100 parts by weight of the first acrylamide-based residue.

The polishing composition for a semiconductor process may further include a second polishing control agent which is a zwitterionic compound.

The second polishing control agent may include at least one selected from the group consisting of a betaine-based compound, an amino acid-based compound, a sulfanilic acid-based compound, a pyridine carboxylic acid-based compound, and derivatives of each thereof.

The polishing composition for a semiconductor process may include 10 parts by weight to 90 parts by weight of the first polishing control agent based on 100 parts by weight of the second polishing control agent.

The first polishing control agent may control a polishing rate of the polishing composition for a semiconductor process with respect to a silicon oxide film.

The second polishing control agent may control a polishing rate of the polishing composition for a semiconductor process with respect to a silicon nitride film.

The polishing composition for a semiconductor process may have a pH of 5.5 to 9.

The polishing particles may include colloidal ceria particles.

A method of manufacturing a substrate according to one embodiment of the present specification includes a process of polishing a substrate by applying, as a slurry, the polishing composition for a semiconductor process.

### [ADVANTAGEOUS EFFECTS OF INVENTION]

The polishing composition for a semiconductor process according to the present disclosure, when applied to a CMP process, may provide a polished substrate having a smoother surface while maintaining a polishing speed of at least a predetermined level.

### [MODE FOR INVENTION]

Hereinafter, examples will be described in detail so that those skilled in the art to which the present disclosure pertains may easily carry out the present disclosure. However, the present disclosure may be embodied in many different forms and is not limited to the examples described herein.

In the present specification, terms of degree such as "about" and "substantially" are used as meanings at or close to the numerical values when a manufacturing and material tolerance inherent in the mentioned meaning is presented, and are used to prevent an unscrupulous infringer from unfairly using disclosure in which accurate or absolute numerical values are stated to help understanding of the present disclosure.

Throughout the present specification, the term "combinations thereof" included in a Markush-type expression means one or more mixtures or combinations selected from a group consisting of components described in the Markush-type expression, and means including one or more selected from the group consisting of the components.

Throughout the present specification, the description of "A and/or B" means "A, B, or A and B."

Throughout the present specification, terms such as "first," "second," or "A," "B" are used to distinguish the same terms from each other unless otherwise stated.

In the present specification, the meaning that B is disposed on A means that B is disposed on A, or that B is disposed on A while another layer is disposed therebetween, and is not construed as being limited to that B is disposed to be in contact with a surface of A.

In the present specification, a singular expression, unless otherwise stated, is construed as including a singular or plural as interpreted in context.

A "-based residue" described in the present specification means a residue derived from a compound applied as a monomer. For example, an acrylamide-based residue means a residue derived from an acrylamide-based compound.

A "-based compound" described in the present specification is construed as including a "-" compound and a derivative thereof. For example, an imidazolium-based compound means a compound including imidazolium and a derivative thereof.

Hereinafter, the present disclosure will be described in detail.

A polishing composition for a semiconductor process according to one embodiment of the present specification includes polishing particles and a first polishing control agent which is a cationic polymer.

### First Polishing Control Agent

The first polishing control agent includes a cationic residue derived from a cationic compound and an acrylamide-based residue.

The acrylamide-based residue includes a first acrylamide-based residue represented by Chemical Formula 1-1 below and a second acrylamide-based residue represented by Chemical Formula 1-2 below, which is distinct from the first acrylamide-based residue.

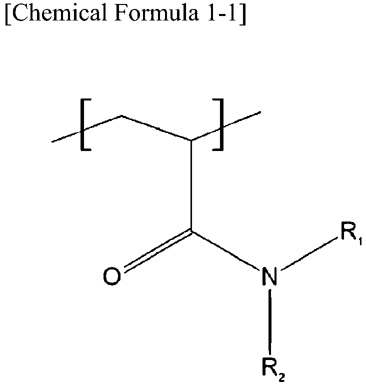

In Chemical Formula 1-1, R₁ and R₂ are each independently hydrogen, a methyl group, or an ethyl group.

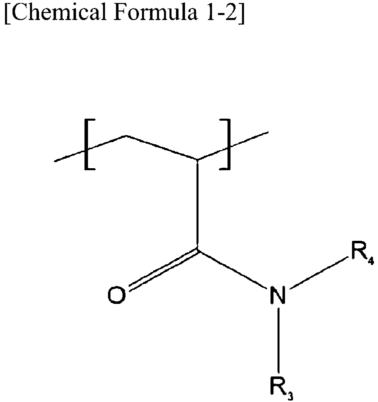

In Chemical Formula 1-2, R₃ is hydrogen, a methyl group, or an ethyl group, and R₄ is an alkyl group having 3 to 10 carbon atoms or an alkoxyalkyl group having 2 to 10 carbon atoms.

The first polishing control agent may be adsorbed onto a thin film having a negatively charged surface, specifically a surface of a silicon oxide film, and may have a function of controlling a polishing rate of the polishing composition with respect to an insulating material within a desired range.

The present disclosure may commonly introduce, into the first polishing control agent, the first acrylamide-based residue and the second acrylamide-based residue, which both have amide groups in side chains and have different side-chain lengths from each other.

In order to form a relatively thick passivation film on a silicon oxide film, introduction of a functional group having a relatively long chain structure into a side chain of a polishing control agent may be considered. However, in this case, due to a steric hindrance effect caused by a bulky structure of the functional group, a cationic functional group of the first polishing control agent may not be stably attached to a surface of a silicon oxide film or the like. In addition, depending on polarity of the introduced functional group, affinity of the first polishing control agent to the polishing composition may be excessively reduced, and dispersibility of the polishing control agent in the polishing composition may deteriorate. These issues may act as factors degrading polishing rate control performance of the first polishing control agent with respect to a silicon oxide film.

The present disclosure may reduce a steric hindrance effect induced from the side chains and may improve dispersibility of the first polishing control agent in the polishing composition by introducing, together, the first acrylamide-based residue and the second acrylamide-based residue having different side-chain lengths into the first polishing control agent. Through this, effective polishing rate control with respect to a silicon oxide film may be achieved, and excessive dishing of the silicon oxide film may be effectively prevented. In addition, such characteristics may also contribute to improving dispersibility of polishing particles in the polishing composition.

In Chemical Formula 1-1, R₁ and R₂ may each independently be hydrogen, a methyl group, or an ethyl group. R₁ and R₂ may each independently be hydrogen or a methyl group. R₁ and R₂ may be hydrogen. In this case, a steric hindrance effect acting on the cationic functional group may be reduced, thereby controlling a polishing rate of the polishing composition with respect to a silicon oxide film within an appropriate range.

In Chemical Formula 1-2, R₄ may be an alkyl group having 3 to 10 carbon atoms or an alkoxyalkyl group having 2 to 10 carbon atoms. R₄ may be an alkyl group having 4 or more carbon atoms. In Chemical Formula 1-2, R₄ may be an alkyl group having 5 or more carbon atoms. R₄ may be an alkoxyalkyl group having 3 or more carbon atoms. R₄ may be an alkoxyalkyl group having 4 or more carbon atoms. In this case, the first polishing control agent may form a more stable passivation film on a silicon oxide film.

The first polishing control agent may further include a vinyl ester-based residue represented by Chemical Formula 2 below.

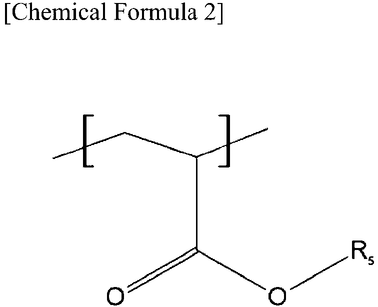

In Chemical Formula 2, R₅ is a hydroxyalkyl group having 1 to 10 carbon atoms.

The vinyl ester-based residue included in the first polishing control agent may contribute to suppressing precipitation of polishing particles, thereby improving dispersibility of the polishing particles and storage stability of the polishing composition, and may help form a dense passivation film on a silicon oxide film.

R₅ may be a hydroxyalkyl group having 1 to 10 carbon atoms. R₅ may be a hydroxyalkyl group having 3 or more carbon atoms. R₅ may be a hydroxyalkyl group having 8 or less carbon atoms. In this case, hydrophilicity of the first polishing control agent may be improved, thereby helping polishing particles to be stably dispersed in the polishing composition. In addition, the residue may help a stable passivation film to be formed on a silicon oxide film.

The cationic residue may have a cationic functional group. Due to an electrostatic interaction formed between the cationic functional group and a thin film having a negatively charged surface, the first polishing control agent may be stably adsorbed onto the thin film having a negatively charged surface.

The cationic residue may be a residue derived from a quaternary ammonium-based compound. In this case, the cationic residue may include a quaternary ammonium group as a cationic functional group.

Examples of the quaternary ammonium-based compound include vinylbenzyltrimethylammonium salt, allyltrimethylammonium salt, diallyldimethylammonium salt, acryloyloxy methyl trimethylammonium salt, acryloyloxyethyl trimethylammonium salt, acryloyloxypropyl trimethylammonium salt, methacryloyloxy methyl trimethylammonium salt, methacryloyloxyethyl trimethylammonium salt, methacryloyloxypropyl trimethylammonium salt, and the like.

In particular, the cationic residue may be a residue derived from a quaternary ammonium-based compound including an acrylate group or a methacrylate group. In this case, affinity of the first polishing control agent to the polishing composition may be improved, and the first polishing control agent may be helped to efficiently form a passivation film on a silicon oxide film.

The first polishing control agent may include 30 wt% to 80 wt% of the cationic residue. The first polishing control agent may include 35 wt% or more of the cationic residue. The first polishing control agent may include 40 wt% or more of the cationic residue. The first polishing control agent may include 75 wt% or less of the cationic residue. The first polishing control agent may include 70 wt% or less of the cationic residue. The first polishing control agent may include 65 wt% or less of the cationic residue.

In this case, adsorption of the first polishing control agent with respect to a silicon oxide film may be improved.

The first polishing control agent may include 3 parts by weight or more of the acrylamide-based residue based on 100 parts by weight of the cationic residue. The first polishing control agent may include 5 parts by weight or more of the acrylamide-based residue based on 100 parts by weight of the cationic residue. The first polishing control agent may include 10 parts by weight or more of the acrylamide-based residue based on 100 parts by weight of the cationic residue. The first polishing control agent may include 20 parts by weight or more of the acrylamide-based residue based on 100 parts by weight of the cationic residue. The first polishing control agent may include 160 parts by weight or less of the acrylamide-based residue based on 100 parts by weight of the cationic residue. The first polishing control agent may include 150 parts by weight or less of the acrylamide-based residue based on 100 parts by weight of the cationic residue.

The first polishing control agent may include the acrylamide-based residue in an amount of 1 wt% to 80 wt%. The first polishing control agent may include 3 wt% or more of the acrylamide-based residue. The first polishing control agent may include 5 wt% or more of the acrylamide-based residue. The first polishing control agent may include 10 wt% or more of the acrylamide-based residue. The first polishing control agent may include 15 wt% or more of the acrylamide-based residue. The first polishing control agent may include 20 wt% or more of the acrylamide-based residue. The first polishing control agent may include 70 wt% or less of the acrylamide-based residue. The first polishing control agent may include 60 wt% or less of the acrylamide-based residue.

The acrylamide-based residue may include 50 parts by weight or more of the second acrylamide-based residue based on 100 parts by weight of the first acrylamide-based residue. The acrylamide-based residue may include 60 parts by weight or more of the second acrylamide-based residue based on 100 parts by weight of the first acrylamide-based residue. The acrylamide-based residue may include 70 parts by weight or more of the second acrylamide-based residue based on 100 parts by weight of the first acrylamide-based residue. The acrylamide-based residue may include 80 parts by weight or more of the second acrylamide-based residue based on 100 parts by weight of the first acrylamide-based residue. The acrylamide-based residue may include 260 parts by weight or less of the second acrylamide-based residue based on 100 parts by weight of the first acrylamide-based residue. The acrylamide-based residue may include 255 parts by weight or less of the second acrylamide-based residue based on 100 parts by weight of the first acrylamide-based residue. The acrylamide-based residue may include 250 parts by weight or less of the second acrylamide-based residue based on 100 parts by weight of the first acrylamide-based residue. The acrylamide-based residue may include 245 parts by weight or less of the second acrylamide-based residue based on 100 parts by weight of the first acrylamide-based residue. The acrylamide-based residue may include 240 parts by weight or less of the second acrylamide-based residue based on 100 parts by weight of the first acrylamide-based residue.

In this case, the first polishing control agent may form a more stable passivation film on a silicon oxide film while effectively suppressing a decrease in adsorption of the cationic functional group with respect to the silicon oxide film.

The first polishing control agent may include 3 parts by weight or more of the vinyl ester-based residue based on 100 parts by weight of the cationic residue. The first polishing control agent may include 5 parts by weight or more of the vinyl ester-based residue based on 100 parts by weight of the cationic residue. The first polishing control agent may include 10 parts by weight or more of the vinyl ester-based residue based on 100 parts by weight of the cationic residue. The first polishing control agent may include 15 parts by weight or more of the vinyl ester-based residue based on 100 parts by weight of the cationic residue. The first polishing control agent may include 20 parts by weight or more of the vinyl ester-based residue based on 100 parts by weight of the cationic residue. The first polishing control agent may include 60 parts by weight or less of the vinyl ester-based residue based on 100 parts by weight of the cationic residue. The first polishing control agent may include 55 parts by weight or less of the vinyl ester-based residue based on 100 parts by weight of the cationic residue. The first polishing control agent may include 50 parts by weight or less of the vinyl ester-based residue based on 100 parts by weight of the cationic residue. The first polishing control agent may include 45 parts by weight or less of the vinyl ester-based residue based on 100 parts by weight of the cationic residue. The first polishing control agent may include 40 parts by weight or less of the vinyl ester-based residue based on 100 parts by weight of the cationic residue. In this case, dispersibility of polishing particles may be improved while allowing the cationic functional group to be easily attached to a surface of a silicon oxide film.

The polishing composition for a semiconductor process may include 0.05 parts by weight or more of the first polishing control agent based on 100 parts by weight of the polishing particles. The polishing composition for a semiconductor process may include 0.1 parts by weight or more of the first polishing control agent based on 100 parts by weight of the polishing particles. The polishing composition for a semiconductor process may include 0.5 parts by weight or more of the first polishing control agent based on 100 parts by weight of the polishing particles. The polishing composition for a semiconductor process may include 0.8 parts by weight or more of the first polishing control agent based on 100 parts by weight of the polishing particles. The polishing composition for a semiconductor process may include 10 parts by weight or less of the first polishing control agent based on 100 parts by weight of the polishing particles. The polishing composition for a semiconductor process may include 8 parts by weight or less of the first polishing control agent based on 100 parts by weight of the polishing particles. The polishing composition for a semiconductor process may include 5 parts by weight or less of the first polishing control agent based on 100 parts by weight of the polishing particles. The polishing composition having such characteristics may effectively suppress over-polishing and dishing of a silicon oxide film when polishing a surface to be polished including the silicon oxide film.

A molecular weight of the first polishing control agent may be 200 g/mol or more. The molecular weight may be 250 g/mol or more. The molecular weight may be 300 g/mol or more. The molecular weight may be 2,000 g/mol or less. The molecular weight may be 1,500 g/mol or less. The molecular weight may be 1,000 g/mol or less. The molecular weight may be 800 g/mol or less. The molecular weight may be 500 g/mol or less. In this case, the first polishing control agent may form a stable passivation film on a silicon oxide film.

The first polishing control agent may have a form of a block copolymer in which homogeneous residues are consecutively arranged. The first polishing control agent may have a form of a copolymer in which the cationic residue and the acrylamide-based residue, or the cationic residue, the acrylamide-based residue, and the vinyl ester-based residue are arranged without a particular order. The first polishing control agent may have a form of an alternating copolymer in which the cationic residue and the acrylamide-based residue, or the cationic residue, the acrylamide-based residue, and the vinyl ester-based residue are alternately arranged.

The first polishing control agent may be manufactured by polymerizing, as monomers, a cationic compound and an acrylamide-based compound in a composition for manufacturing the first polishing control agent. The first polishing control agent may be manufactured by polymerizing, as monomers, a cationic compound, an acrylamide-based compound, and a vinyl ester-based compound.

The first polishing control agent may be formed by addition polymerization of the respective monomers. Specifically, the first polishing control agent may be manufactured by adding a radical polymerization initiator to a composition including the respective monomers and performing an addition polymerization reaction.

The composition for manufacturing the first polishing control agent may further include an additive, as needed, such as a pH adjusting agent, in addition to the monomers and the radical polymerization initiator.

However, a method of preparing the first polishing control agent is not limited to the above-described methods.

### Second Polishing Control Agent

The polishing composition for a semiconductor process may further include a second polishing control agent which is a zwitterionic compound.

A zwitterionic compound means a compound having both a cationic functional group and an anionic functional group in the polishing composition.

The second polishing control agent may control a polishing rate of the polishing composition with respect to a silicon nitride film. Specifically, the second polishing control agent may selectively adsorb onto a thin film having a positively charged surface, such as a silicon nitride film, through electrostatic interaction. Through this, a polishing selectivity of a silicon oxide film with respect to a silicon nitride film may be improved, and excessive polishing of a surface to be polished may be suppressed when polishing a substrate surface in which a silicon oxide film and a silicon nitride film are exposed together.

The second polishing control agent may include at least one selected from the group consisting of a betaine-based compound, an amino acid-based compound, a sulfanilic acid-based compound, a pyridine carboxylic acid-based compound, and derivatives of each thereof.

Examples of the betaine-based compound include cocamidopropyl betaine, cocobetaine, cocodimethylcarboxymethyl betaine, lauryldimethylcarboxymethyl betaine, lauryldimethyl-alpha-carboxyethyl betaine, cetyldimethyl-carboxymethyl betaine, lauryl-bis-(2-hydroxyethyl)carboxymethyl betaine, stearyl-bis-(2-hydroxypropyl)carboxymethyl betaine, oleyl dimethyl gamma-carboxypropyl betaine, lauryl-bis-(2-hydroxypropyl)alpha-carboxyethyl betaine, cocodimethyl sulfopropyl betaine, stearyl dimethyl sulfopropyl betaine, cocoamido dimethyl carboxymethyl betaine, cocoamido dimethyl sulfopropyl betaine, laurylamido dimethyl carboxymethyl betaine, cetylamido dimethyl carboxymethyl betaine, and stearylamido dimethyl sulfopropyl betaine.

Examples of the amino acid-based compound include valine, leucine, isoleucine, threonine, methionine, lysine, phenylalanine, tryptophan, glycine, alanine, glutamic acid, arginine, cystine, cysteine, proline, serine, tyrosine, asparagine, aspartic acid, and histidine.

Examples of the sulfanilic acid-based compound include [2-(methacryloyloxy)ethyl]-dimethyl-(4-sulfobutyl)-ammonium hydroxide, [2-(methacryloyloxy)ethyl]-dimethyl-(5-sulfopentyl)-ammonium hydroxide, [2-(acryloyloxy)ethyl]-dimethyl-(2-sulfoethyl)-ammonium hydroxide, and [2-(acryloyloxy)ethyl]-dimethyl-(3-sulfopropyl)-ammonium hydroxide.

Examples of the pyridine carboxylic acid-based compound include pyridine-2-carboxylic acid, pyridine-3-carboxylic acid, pyridine-4-carboxylic acid, pyridine-2,3-dicarboxylic acid, and pyridine-2-amine.

The polishing composition for a semiconductor process may include 10 parts by weight to 90 parts by weight of the first polishing control agent based on 100 parts by weight of the second polishing control agent. The polishing composition for a semiconductor process may include 20 parts by weight or more of the first polishing control agent based on 100 parts by weight of the second polishing control agent. The polishing composition for a semiconductor process may include 30 parts by weight or more of the first polishing control agent based on 100 parts by weight of the second polishing control agent. The polishing composition for a semiconductor process may include 90 parts by weight or less of the first polishing control agent based on 100 parts by weight of the second polishing control agent. The polishing composition for a semiconductor process may include 80 parts by weight or less of the first polishing control agent based on 100 parts by weight of the second polishing control agent. The polishing composition for a semiconductor process may include 70 parts by weight or less of the first polishing control agent based on 100 parts by weight of the second polishing control agent. In this case, when polishing a substrate surface in which a silicon oxide film and a silicon nitride film are exposed together, skew and dishing of the polished surface may be simultaneously suppressed. Skew means excessive polishing of a silicon nitride film.

The polishing composition for a semiconductor process may include 0.5 parts by weight or more of the second polishing control agent based on 100 parts by weight of the polishing particles. The polishing composition for a semiconductor process may include 1 part by weight or more of the first polishing control agent based on 100 parts by weight of the polishing particles. The polishing composition for a semiconductor process may include 2 parts by weight or more of the first polishing control agent based on 100 parts by weight of the polishing particles. The polishing composition for a semiconductor process may include 20 parts by weight or less of the first polishing control agent based on 100 parts by weight of the polishing particles. The polishing composition for a semiconductor process may include 15 parts by weight or less of the first polishing control agent based on 100 parts by weight of the polishing particles. The polishing composition for a semiconductor process may include 10 parts by weight or less of the first polishing control agent based on 100 parts by weight of the polishing particles. The polishing composition having such characteristics may have controlled polishing characteristics with respect to a silicon nitride film.

### Polishing Particles and Other Compound

The polishing particles may include colloidal ceria particles. Compared to ceria formed by a solid-phase method, colloidal ceria may have higher density and crystallinity, and such characteristics may impart improved polishing properties to the polishing composition. In addition, colloidal ceria may have a relatively uniform particle shape and particle size distribution, and may effectively reduce a frequency of defect occurrence on a polished surface.

The polishing particles may have an average diameter of secondary particles of 100 nm or more. The average diameter may be 110 nm or more. The average diameter may be 120 nm or more. The average diameter may be 130 nm or more. The average diameter may be 170 nm or less. The average diameter may be 160 nm or less. The average diameter may be 150 nm or less. A polishing composition to which such particles are applied may exhibit an excellent polishing rate with respect to a substrate surface while reducing a frequency of defects such as scratches on the polished surface.

An average diameter of primary particles of the polishing particles may be 30 nm or more. The average diameter may be 40 nm or more. The average diameter may be 50 nm or more. The average diameter may be 200 nm or less. The average diameter may be 180 nm or less. The average diameter may be 150 nm or less. The average diameter may be 120 nm or less. In this case, while stably controlling a frequency at which polishing particles are adsorbed onto a substrate, the polishing composition may exhibit an excellent polishing rate with respect to the substrate surface.

The polishing particles may include 50 wt% or more of colloidal ceria particles. The polishing particles may include 70 wt% or more of colloidal ceria particles. The polishing particles may include 90 wt% or more of colloidal ceria particles. The polishing particles may include 100 wt% or less of colloidal ceria particles. The polishing particles may be colloidal ceria particles.

The polishing composition for a semiconductor process may include 1 wt% or more of the polishing particles. The polishing composition for a semiconductor process may include 2 wt% or more of the polishing particles. The polishing composition for a semiconductor process may include 3 wt% or more of the polishing particles. The polishing composition for a semiconductor process may include 20 wt% or less of the polishing particles. The polishing composition for a semiconductor process may include 15 wt% or less of the polishing particles. The polishing composition for a semiconductor process may include 10 wt% or less of the polishing particles. In this case, efficient polishing may be possible particularly with respect to a substrate surface on which an oxide film and a nitride film are simultaneously exposed.

The polishing composition for a semiconductor process may further include a nonionic polymer. The nonionic polymer may improve dispersibility of the polishing particles. Specifically, the nonionic polymer may be adsorbed onto the polishing particles to increase dispersibility, and a nonionic polymer that is not adsorbed may further enhance dispersion stability through a steric hindrance effect or the like. In addition, the polymer, being nonionic, allows the polishing composition for a semiconductor process to have more stable dispersion stability even in an acidic environment described below. Further, defects caused by polishing on a substrate may be reduced during a polishing process.

The nonionic polymer may be at least one of polyethylene glycol, polypropylene glycol, polyvinylpyrrolidone, polyethylene oxide, polypropylene oxide, polyalkyl oxide, polyoxyethylene oxide, a polyethylene oxide-propylene oxide copolymer, cellulose, methylcellulose, methyl hydroxyethyl cellulose, methyl hydroxypropyl cellulose, hydroxyethyl cellulose, carboxymethyl cellulose, carboxymethyl hydroxyethyl cellulose, sulfoethyl cellulose, or carboxymethyl sulfoethyl cellulose.

The nonionic polymer may have a weight-average molecular weight of 1,000 g/mol or more and less than 25,000 g/mol. When such a range is applied, better solubility and dispersion stability may be exhibited, and polishing characteristics may also be advantageous.

The nonionic polymer may be included in an amount of 0.01 wt% to 5 wt%, or 0.1 wt% to 2 wt%, based on the total polishing composition for a semiconductor process. In this case, while suppressing occurrence of defects on a polished substrate surface, a degree of contamination such as re-adhesion of particles onto the polished substrate surface may be controlled to be at or below a certain level.

The polishing composition for a semiconductor process may further include a chelator. The chelator allows metals or metal ions to be adsorbed and easily removed. Specifically, metals that may be generated during polishing may be re-adsorbed onto a polished surface or remain in a subsequent process and cause defects. In particular, metals such as tungsten are relatively easily dissolved under specific environments but are also easily re-attached to a surface, and thus a chelator may be applied as a sequestrant to prevent this.

For example, the chelator may be at least one of butyric acid, citric acid, tartaric acid, succinic acid, oxalic acid, acetic acid, adipic acid, capric acid, caproic acid, caprylic acid, carboxylic acids, glutaric acid, glutamic acid, glycolic acid, thioglycolic acid, formic acid, mandelic acid, fumaric acid, lactic acid, lauric acid, malic acid, maleic acid, malonic acid, myristic acid, palmitic acid, phthalic acid, isophthalic acid, terephthalic acid, citraconic acid, propionic acid, pyruvic acid, stearic acid, valeric acid, benzoic acid, phenylacetic acid, naphthoic acid, aspartic acid, amino acids, or ethylenediaminetetraacetic acid. As the amino acids, glycine, α-alanine, β-alanine, L-aspartic acid, N-methylglycine (methylglycine), and combinations thereof may be applied.

The chelator may include two or more carboxyl groups or alcohol groups in a molecule. Two or more chelators each including two or more carboxyl groups or alcohol groups in a molecule may be applied. Specifically, the chelator may include any one selected from the group consisting of EDTA (ethylenediaminetetraacetic acid), glycine, carboxylic acids, and combinations thereof. The carboxylic acid means a compound including at least one or more carboxyl groups in a molecule.

The chelator may be included in an amount of 0.003 wt% to 0.5 wt%, or 0.005 wt% to 0.3 wt%, based on the total polishing composition for a semiconductor process. In this case, a frequency of defect occurrence due to particles derived from a metal thin film may be reduced.

The polishing composition for a semiconductor process may further include an oxidizing agent. The oxidizing agent oxidizes a metal thin film to create an environment in which planarization may be more easily performed, and serves to improve a polishing rate and an etching rate.

The oxidizing agent may be at least one of hydrogen peroxide, urea hydrogen peroxide, urea, percarbonate, periodic acid, periodate, perchloric acid, perchlorate, perbromic acid, perbromate, perboric acid, perborate, permanganic acid, permanganate, persulfate, bromate, chlorate, hypochlorite, chromate, iodate, iodic acid, ammonium persulfate, benzoyl peroxide, calcium peroxide, barium peroxide, sodium peroxide, or carbamide peroxide.

The oxidizing agent may be included in an amount of 0.01 wt% to 5 wt% based on the total polishing composition for a semiconductor process. In this case, an oxidation degree of a metal thin film may be controlled to adjust a polishing rate within a stable range.

In order to adjust a pH of the polishing composition for a semiconductor process, an acid component may be further added to the composition in addition to a solvent. The acid component may be applied together with a pH adjusting agent.

For example, the acid component may be at least one of hydrochloric acid, phosphoric acid, sulfuric acid, hydrofluoric acid, bromic acid, iodic acid, formic acid, malonic acid, maleic acid, oxalic acid, acetic acid, adipic acid, citric acid, adipic acid, acetic acid, propionic acid, fumaric acid, lactic acid, salicylic acid, pimelic acid, benzoic acid, succinic acid, phthalic acid, butyric acid, glutaric acid, glutamic acid, glycolic acid, lactic acid, aspartic acid, tartaric acid, or salts thereof.

The pH adjusting agent may be any one selected from the group consisting of ammonia, aminomethylpropanol, tetramethylammonium hydroxide, potassium hydroxide, sodium hydroxide, magnesium hydroxide, rubidium hydroxide, cesium hydroxide, sodium bicarbonate, sodium carbonate, imidazole, and combinations thereof.

The acid component and the pH adjusting agent may be applied in appropriate amounts in accordance with an intended pH.

The polishing composition for a semiconductor process may further include a dispersant. The dispersant may have an anionic functional group exhibiting a negative charge in the polishing composition. By binding of the anionic functional group to polishing particles exhibiting a positive charge, a complex may be formed between the dispersant and the polishing particles. Examples of the dispersant include poly(acrylic acid), poly(acrylic acid-co-maleic acid), poly(methyl vinyl ether-alt-maleic acid), polyacrylamide, poly(acrylamide-co-acrylic acid), and polyacrylonitrile.

The polishing composition for a semiconductor process includes a solvent as a remaining component except for the components described above and additional components described later. The solvent may be water, and preferably ultrapure water is applied.

### Physical Properties of Polishing Composition

The polishing composition for a semiconductor process may have a pH of 5.5 to 9. The pH may be 6 or more. The pH may be 7 or more. The pH may be 8.5 or less. The pH may be 8 or less. Such conditions may help the first polishing control agent and the second polishing control agent to stably form passivation layers on a silicon oxide film and a silicon nitride film, respectively. In addition, in the polishing composition having such characteristics, aggregation of polishing particles may be suppressed.

A zeta potential of the polishing composition for a semiconductor process may be -60 mV or more. The zeta potential may be -50 mV or more. The zeta potential may be -45 mV or more. The zeta potential may be -40 mV or more. The zeta potential may be 0 mV or less. The zeta potential may be -10 mV or less. The zeta potential may be -20 mV or less. In this case, dispersibility of polishing particles and polishing control capability of polishing control agents may be simultaneously improved, and the polishing composition may form a substrate surface with reduced defects through polishing.

An electrical conductivity of the polishing composition for a semiconductor process may be 1000 µS/cm or more. The electrical conductivity may be 1100 µS/cm or more. The electrical conductivity may be 1200 µS/cm or more. The electrical conductivity may be 1500 µS/cm or less. The electrical conductivity may be 1400 µS/cm or less. In this case, polishing particles may be stably dispersed in the polishing composition.

The pH, zeta potential, and electrical conductivity of the polishing composition are measured by measurement methods commonly applied in the field of polishing compositions for semiconductor processes.

The polishing rate of the polishing composition for a semiconductor process with respect to a silicon oxide film may be 2000 Å/min or more. The polishing rate may be 2300 Å/min or more. The polishing rate may be 2500 Å/min or more. The polishing rate may be 5000 Å/min or less.

The polishing rate of the polishing composition for a semiconductor process with respect to a silicon nitride film may be 300 Å/min or less. The polishing rate may be 250 Å/min or less. The polishing rate may be 200 Å/min or less. The polishing rate may be 180 Å/min or less. The polishing rate may be 150 Å/min or less. The polishing rate may be 50 Å/min or more.

The polishing composition for a semiconductor process may have a polishing selectivity of a silicon oxide film with respect to a silicon nitride film of 23 or more. The polishing selectivity may be 24 or more. The polishing selectivity may be 25 or more. The polishing selectivity may be 26 or more. The polishing selectivity may be 35 or less. In this case, excessive step differences on a polished surface may be effectively suppressed when polishing a surface in which a silicon oxide film and a silicon nitride film are simultaneously exposed.

The polishing composition for a semiconductor process may have a silicon oxide film dishing value of 600 Å or less when polishing a substrate including a silicon nitride film and a silicon oxide film, and having a pattern density of 50% for 200 seconds.

When measuring the dishing value, a pattern wafer including a silicon oxide film and a silicon nitride film, and having a pitch of 1000 µm and pattern density of 50% is applied as a substrate to be polished, and a carrier/platen speed of 93/78 RPM, a slurry flow rate of 250 mL/min, and a polishing pressure of 5.2 psi are applied. When measuring the dishing value, an HD-500C pad manufactured by SK Enpulse Co., Ltd. may be applied as a polishing pad.

Polishing the substrate for 200 seconds means polishing a substrate having a planar surface for 200 seconds, or polishing a substrate having step differences on an upper portion thereof and further polishing the substrate for 200 seconds from a time point at which the substrate starts to have a planar surface.

The polishing composition for a semiconductor process may have a silicon oxide film dishing value of 600 Å or less when polishing a substrate including a silicon nitride film and a silicon oxide film, and having a pattern density of 50% for 200 seconds. The dishing value may be 500 Å or less. The dishing value may be 450 Å or less. The dishing value may be 400 Å or less. The dishing value may be 380 Å or less. The dishing value may be 100 Å or more. The composition having such characteristics may provide a more planar polished surface.

The polishing composition for a semiconductor process may have a silicon nitride film skew value of 500 Å or less when polishing a substrate including a silicon nitride film and a silicon oxide film, and having a pattern density of 50% for 200 seconds.

A skew value of the silicon nitride film means a depth to which the silicon nitride film is polished during polishing of a substrate.

When measuring the skew of the silicon nitride film, polishing conditions are the same as those applied when measuring the dishing value of the silicon oxide film.

The polishing composition for a semiconductor process may have a silicon nitride film skew value of 500 Å or less when polishing a substrate including a silicon nitride film and a silicon oxide film, and having a pattern density of 50% for 200 seconds. The skew value may be 400 Å or less. The skew value may be 350 Å or less. The skew value may be 300 Å or less. The skew value may be 280 Å or less. The skew value may be 250 Å or less. The skew value may be 50 Å or more. In this case, a degree of step difference occurrence on a polished surface due to over-polishing may be effectively suppressed.

A polishing composition for a semiconductor process according to another embodiment of the present specification includes polishing particles and a first polishing control agent which is a cationic polymer.

The first polishing control agent includes a cationic residue derived from a cationic compound and a vinyl ester-based residue represented by Chemical Formula 2 below.

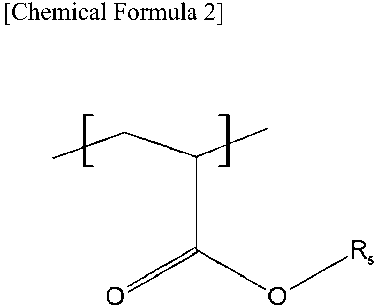

In Chemical Formula 2,
R₅ is a hydroxyalkyl group having 1 to 10 carbon atoms.

The first polishing control agent may include 3 parts by weight to 120 parts by weight of the vinyl ester-based residue based on 100 parts by weight of the cationic residue. The first polishing control agent may include 10 parts by weight or more of the vinyl ester-based residue based on 100 parts by weight of the cationic residue. The first polishing control agent may include 20 parts by weight or more of the vinyl ester-based residue based on 100 parts by weight of the cationic residue. The first polishing control agent may include 30 parts by weight or more of the vinyl ester-based residue based on 100 parts by weight of the cationic residue. The first polishing control agent may include 100 parts by weight or less of the vinyl ester-based residue based on 100 parts by weight of the cationic residue. The first polishing control agent may include 80 parts by weight or less of the vinyl ester-based residue based on 100 parts by weight of the cationic residue. In this case, adsorption of the first polishing control agent with respect to a silicon oxide film may be improved, and a stable passivation film may be formed on the silicon oxide film. In addition, the first polishing control agent may contribute to stable dispersion of polishing particles.

The polishing composition for a semiconductor process may further include a second polishing control agent which is a zwitterionic compound.

The polishing composition for a semiconductor process may further include an additive such as the nonionic polymer, chelator, oxidizing agent, pH adjusting agent, and/or dispersant described above.

Descriptions of the polishing particles, the cationic residue and the vinyl ester-based residue of the first polishing control agent, the second polishing control agent, and other additives are omitted as being redundant with the above description.

### Method of Manufacturing a Substrate

A method of manufacturing a substrate according to another embodiment of the present specification includes a process of polishing a substrate by applying, as a slurry, the polishing composition for a semiconductor process described above.

The substrate may include, on an upper surface thereof, at least one of an insulating film, a metal wiring, or a barrier layer. The metal wiring may include copper or tungsten. When the metal wiring includes copper, the barrier layer may include tantalum and a nitride thereof. When the metal wiring includes tungsten, the barrier layer may include titanium and a nitride thereof. The insulating film may include a silicon nitride film or a silicon oxide film.

Specifically, the process of polishing the substrate may be performed by bringing a substrate to be polished into contact with a polishing pad together with the polishing composition for a semiconductor process supplied from a spray nozzle, while a polishing head fixing the substrate rotates and a platen to which the polishing pad is attached also rotates.

The process of polishing the substrate may further include, as necessary, a process of conditioning a surface of the polishing pad before polishing.

The polishing composition for a semiconductor process may polish a wafer that is in contact with the polishing pad while penetrating toward the substrate.

In the process of polishing the substrate, a pressure of 6.89 kPa to 48.26 kPa may be applied. The pressure may be 13.79 kPa to 34.47 kPa.

The process of polishing the substrate may be performed for 50 seconds to 10 minutes. However, the process may be changed according to a desired polishing degree.

Descriptions of the polishing composition for a semiconductor process are omitted as being redundant with the above description.

The method of manufacturing a substrate may further include a cleaning process of cleaning the substrate after polishing.

The cleaning process may be performed by cleaning the polished substrate with purified water and an inert gas.

Hereinafter, specific examples will be described in more detail.

### Preparation Example: Preparation of Polishing Composition for Semiconductor Process

Comparative Example 1: A polishing composition for a semiconductor process was prepared by including, as a solvent, ultrapure water, 5.5 wt% of ceria particles manufactured by Solvay, 0.165 wt% of picolinic acid as a second polishing control agent, 0.275 wt% of polyethylene glycol, 0.0275 wt% of polyacrylic acid, 0.038 wt% of 2-amino-2-ethyl-1,3-propanediol, and 0.035 wt% of nitric acid.

Example 1: A polishing composition for a semiconductor process was prepared in the same manner as in Comparative Example 1, except that 0.06 wt% of the first polishing control agent was additionally applied (with ultrapure water excluded by a corresponding amount).

As the first polishing control agent, a compound having a molecular weight of 300 g/mol to 500 g/mol and including 17.75 wt% of a first acrylamide-based residue derived from acrylamide, 39.25 wt% of a second acrylamide-based residue derived from acrylamide including a butoxymethyl group, and 43 wt% of a cationic residue derived from a methacrylate-based compound including a quaternary ammonium group was applied.

Example 2: A polishing composition for a semiconductor process was prepared in the same manner as in Comparative Example 1, except that 0.11 wt% of the first polishing control agent was applied (with ultrapure water excluded by a corresponding amount).

Example 3: A polishing composition for a semiconductor process was prepared in the same manner as in Comparative Example 1, except that 0.248 wt% of picolinic acid and 0.06 wt% of the first polishing control agent were applied (with ultrapure water excluded by corresponding amounts).

Example 4: A polishing composition for a semiconductor process was prepared in the same manner as in Comparative Example 1, except that 0.330 wt% of picolinic acid and 0.06 wt% of the first polishing control agent were applied (with ultrapure water excluded by corresponding amounts).

Compositions of the polishing compositions for semiconductor processes applied to Examples and Comparative Example are shown in Table 1 below.

Secondary particle diameters of polishing particles and zeta potentials of the polishing compositions for semiconductor processes applied to Examples and Comparative Example were measured using a Zetasizer-Nano manufactured by Malvern, and pH and electrical conductivity were measured using an F-74BW pH meter manufactured by Horiba. Measured values are shown in Table 2 below.

### Evaluation Example: Measurement of Dishing Value of Silicon Oxide Film and Skew Value of Silicon Nitride Film

Substrates including a silicon nitride film and a silicon oxide film, having a planar surface and a pattern density of 50%, were polished for 200 seconds by applying the polishing compositions for semiconductor processes according to Examples and Comparative Example. During polishing, an HD-500C polishing pad manufactured by SK Enpulse Co., Ltd. was applied, a carrier/platen speed was set to 93/87 RPM, a slurry flow rate was set to 250 mL/min, and a polishing pressure was set to 5.2 psi.

After polishing, a step difference of the polished silicon oxide film was measured, and the measured value was defined as a dishing value of the silicon oxide film.

In addition, a polished depth of the silicon nitride film was measured, and the measured value was defined as a skew value of the silicon nitride film.

Measurement results for Examples and Comparative Example are shown in Table 3 below.

### Evaluation Example: Measurement of Polishing Rates for Silicon Oxide Film and Silicon Nitride Film

Silicon nitride film wafers and silicon oxide film wafers were each polished for 360 seconds by applying the polishing compositions for semiconductor processes according to Examples and Comparative Example. During polishing, a polishing pressure was set to 5.2 psi.

After polishing, polished depths of the silicon oxide film and the silicon nitride film in the substrates were measured, and polishing rates were calculated from the measured values. In addition, a polishing selectivity of the silicon oxide film with respect to the silicon nitride film was calculated from the polishing rate of the silicon oxide film and the polishing rate of the silicon nitride film.

Measurement results for Examples and Comparative Example are shown in Table 3 below.

**[Table 1]**

| | Polishing Particles (wt%) | First Polishing Control Agent (wt%) | Second Polishing Control Agent (wt%) | Polyethylene Glycol (wt%) | Polyacrylic Acid (wt%) | 2-Amino-2-ethyl-1,3-propanediol (wt%) | Nitric Acid (wt%) |
|---|---|---|---|---|---|---|---|
| Comparative Example 1 | 5.5 | 0 | 0.165 | 0.275 | 0.0275 | 0.038 | 0.035 |
| Example 1 | 5.5 | 0.06 | 0.165 | 0.275 | 0.0275 | 0.038 | 0.035 |
| Example 2 | 5.5 | 0.11 | 0.165 | 0.275 | 0.0275 | 0.038 | 0.035 |
| Example 3 | 5.5 | 0.06 | 0.248 | 0.275 | 0.0275 | 0.038 | 0.035 |
| Example 4 | 5.5 | 0.06 | 0.330 | 0.275 | 0.0275 | 0.038 | 0.035 |

**[Table 2]**

| | Secondary Particle Diameter (nm) | pH | Electrical Conductivity (µs/cm) | Zeta Potential (mV) |
|---|---|---|---|---|
| Comparative Example 1 | 140.5 | 7.8 | 1280 | -41 |
| Example 1 | 140.2 | 7.75 | 1288 | -39 |
| Example 2 | 142.1 | 7.77 | 1297 | -38 |
| Example 3 | 140.3 | 7.75 | 1295 | -40 |
| Example 4 | 141.2 | 7.81 | 1315 | -37 |

**[Table 3]**

| | Dishing Value of Silicon Oxide Film (Å) | Skew Value of Silicon Nitride Film (Å) | Polishing Rate for Silicon Oxide Film (Å/min) | Polishing Rate for Silicon Nitride Film (Å/min) | Polishing Selectivity |
|---|---|---|---|---|---|
| Comparative Example 1 | 594 | 438 | 2976 | 116 | 25.7 |
| Example 1 | 408 | 274 | 2859 | 118 | 24.2 |
| Example 2 | 307 | 260 | 2705 | 121 | 22.4 |
| Example 3 | 346 | 236 | 2859 | 106 | 27.0 |
| Example 4 | 348 | 222 | 2827 | 102 | 27.7 |

As shown in Table 3, Examples 1 to 4 exhibited lower dishing values and skew values than Comparative Example 1. In particular, when Comparative Example 1 and Examples 1 and 2 are compared together, it can be confirmed that as an amount of the first polishing control agent increases, a dishing value of the silicon oxide film decreases.

In addition, when Comparative Example 1 and Examples 3 and 4 are compared together, it can be confirmed that as an amount of the second polishing control agent increases, a polishing rate for the silicon nitride film and a skew value of the silicon nitride film decrease, and a polishing selectivity increases.

Although preferred embodiments have been described in detail above, a scope of rights of the present invention is not limited thereto, and various modifications and improvements by those skilled in the art using a basic concept of the present disclosure as defined in the following claims also fall within the scope of the present invention.

## Claims

1. A polishing composition for a semiconductor process, comprising:
polishing particles; and
a first polishing control agent which is a cationic polymer,
wherein the first polishing control agent comprises a cationic residue derived from a cationic compound and an acrylamide-based residue,
wherein the acrylamide-based residue comprises a first acrylamide-based residue represented by Chemical Formula 1-1 below and a second acrylamide-based residue represented by Chemical Formula 1-2 below, which is distinct from the first acrylamide-based residue. 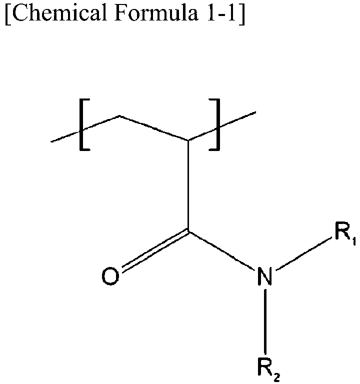
wherein, in Chemical Formula 1-1,
R₁ and R₂ are each independently hydrogen, a methyl group, or an ethyl group. 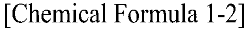 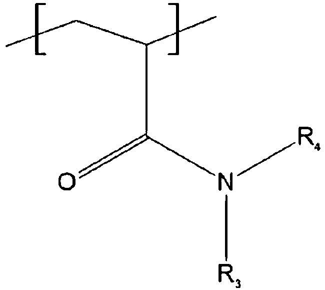
wherein, in Chemical Formula 1-2,
R₃ is hydrogen, a methyl group, or an ethyl group, and
R₄ is an alkyl group having 3 to 10 carbon atoms or an alkoxyalkyl group having 2 to 10 carbon atoms.

2. A polishing composition for a semiconductor process, comprising:
polishing particles; and
a first polishing control agent which is a cationic polymer,
wherein the first polishing control agent comprises a cationic residue derived from a cationic compound and a vinyl ester-based residue represented by Chemical Formula 2 below. 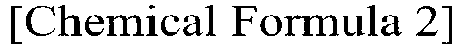 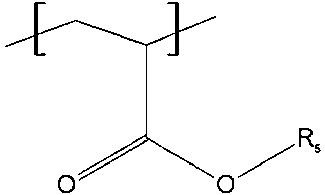
wherein, in Chemical Formula 2,
R₅ is a hydroxyalkyl group having 1 to 10 carbon atoms.

3. The polishing composition for a semiconductor process according to claim 1 or claim 2,
wherein the cationic residue is a residue derived from a quaternary ammonium-based compound.

4. The polishing composition for a semiconductor process according to claim 1 or claim 2,
wherein the first polishing control agent comprises 3 parts by weight to 160 parts by weight of the acrylamide-based residue based on 100 parts by weight of the cationic residue.

5. The polishing composition for a semiconductor process according to claim 1,
wherein the acrylamide-based residue comprises 50 parts by weight to 260 parts by weight of the second acrylamide-based residue based on 100 parts by weight of the first acrylamide-based residue.

6. The polishing composition for a semiconductor process according to claim 1 or claim 2,
further comprising a second polishing control agent which is a zwitterionic compound,
wherein the second polishing control agent comprises at least one selected from the group consisting of a betaine-based compound, an amino acid-based compound, a sulfanilic acid-based compound, a pyridine carboxylic acid-based compound, and derivatives of each thereof.

7. The polishing composition for a semiconductor process according to claim 6,
wherein the polishing composition comprises 10 parts by weight to 90 parts by weight of the first polishing control agent based on 100 parts by weight of the second polishing control agent.

8. The polishing composition for a semiconductor process according to claim 6,
wherein the first polishing control agent controls a polishing rate of the polishing composition for a semiconductor process with respect to a silicon oxide film, and
wherein the second polishing control agent controls a polishing rate of the polishing composition for a semiconductor process with respect to a silicon nitride film.

9. The polishing composition for a semiconductor process according to claim 1 or claim 2,
wherein the polishing composition has a pH of 5.5 to 9.

10. The polishing composition for a semiconductor process according to claim 1 or claim 2,
wherein the polishing particles comprise colloidal ceria particles.

11. A method of manufacturing a substrate, comprising:
polishing a substrate by applying, as a slurry, the polishing composition for a semiconductor process according to claim 1 or claim 2.
